(19) Europäisches Patentamt / European Patent Office / Office européen des brevets

(11) **EP 2 865 011 B1**

(12) **EUROPÄISCHE PATENTSCHRIFT**

(45) Veröffentlichungstag und Bekanntmachung des Hinweises auf die Patenterteilung:
**13.11.2019 Patentblatt 2019/46**

(21) Anmeldenummer: **13729727.1**

(22) Anmeldetag: **19.06.2013**

(51) Int Cl.:
*H01L 31/032* (2006.01)      *H01L 31/18* (2006.01)
*H01L 31/0392* (2006.01)

(86) Internationale Anmeldenummer:
**PCT/EP2013/062703**

(87) Internationale Veröffentlichungsnummer:
**WO 2013/189968 (27.12.2013 Gazette 2013/52)**

(54) **SCHICHTSYSTEM FÜR DÜNNSCHICHT-SOLARZELLEN MIT EINER NAXINISYCLZ-PUFFERSCHICHT**

LAYER SYSTEM FOR THIN FILM SOLAR CELLS WITH NAXIN1SYCLZ BUFFER LAYER

SYSTÈME DE COUCHE POUR CELLULES SOLAIRES À COUCHE MINCE AVEC COUCHE-TAMPON EN NAXIN1SYCLZ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **20.06.2012 EP 12172699**

(43) Veröffentlichungstag der Anmeldung:
**29.04.2015 Patentblatt 2015/18**

(73) Patentinhaber: **(CNBM) Bengbu Design & Research Institute for Glass Industry Co., Ltd. Bengbu (CN)**

(72) Erfinder:
- **HAPP, Thomas**
  **81825 München (DE)**
- **JOST, Stefan**
  **81543 München (DE)**
- **PALM, Jörg**
  **80797 München (DE)**
- **POHLNER, Stephan**
  **81541 München (DE)**
- **DALIBOR, Thomas**
  **82211 Herrsching am Ammersee (DE)**
- **DIETMÜLLER, Roland**
  **80636 München (DE)**

(74) Vertreter: **Gebauer, Dieter Edmund Splanemann Patentanwälte Partnerschaft Rumfordstraße 7 80469 München (DE)**

(56) Entgegenhaltungen:
- **IVER LAUERMANN ET AL: "Synchrotron-based spectroscopy for the characterization of surfaces and interfaces in chalcopyrite thin-film solar cells", SOLAR ENERGY MATERIALS AND SOLAR CELLS, ELSEVIER SCIENCE PUBLISHERS, AMSTERDAM, NL, Bd. 95, Nr. 6, 17. Dezember 2010 (2010-12-17), Seiten 1495-1508, XP028191981, ISSN: 0927-0248, DOI: 10.1016/J.SOLMAT.2010.12.042 [gefunden am 2010-12-27] in der Anmeldung erwähnt**
- **BÄR M ET AL: "Deposition of In2S3 on Cu(In,Ga)(S,Se)2 thin film solar cell absorbers by spray ion layer gas reaction: Evidence of strong interfacial diffusion", APPLIED PHYSICS LETTERS, AIP, AMERICAN INSTITUTE OF PHYSICS, MELVILLE, NY, US, Bd. 90, Nr. 13, 29. März 2007 (2007-03-29) , Seiten 132118-132118, XP012093828, ISSN: 0003-6951, DOI: 10.1063/1.2717534 in der Anmeldung erwähnt**

- BARREAU N ET AL: "A study of bulk NaxCu1-xIn5S8 and its impact on the Cu(In,Ga)Se2/In2S3 interface of solar cells", SOLAR ENERGY MATERIALS AND SOLAR CELLS, ELSEVIER SCIENCE PUBLISHERS, AMSTERDAM, NL, Bd. 90, Nr. 12, 24. Juli 2006 (2006-07-24) , Seiten 1840-1848, XP028002140, ISSN: 0927-0248, DOI: 10.1016/J.SOLMAT.2005.11.008 [gefunden am 2006-07-24]
- Tina Sebastian: "Automation of Chemical Spray Pyrolysis Unit and Fabrication of Sprayed CuInS2/In2S3 Solar Cell", Dissertation, August 2009 (2009-08), XP055070766, Gefunden im Internet: URL:http://dyuthi.cusat.ac.in/jspui/bitstr eam/purl/1954/15/Dyuthi-T0377.pdf [gefunden am 2013-07-11]
- AXEL EICKE ET AL: "Chemical characterisation of evaporated In2Sx buffer layers in Cu(In,Ga)Se2 thin-film solar cells with SNMS and SIMS", SURFACE AND INTERFACE ANALYSIS, Bd. 40, Nr. 3-4, 26. März 2008 (2008-03-26), Seiten 830-833, XP055009784, ISSN: 0142-2421, DOI: 10.1002/sia.2856
- N. NAGHAVI ET AL: "Buffer layers and transparent conducting oxides for chalcopyrite Cu(In,Ga)(S,Se)2 based thin film photovoltaics: present status and current developments", PROGRESS IN PHOTOVOLTAICS: RESEARCH AND APPLICATIONS, Bd. 18, Nr. 6, 24. August 2010 (2010-08-24), Seiten 411-433, XP055029315, ISSN: 1062-7995, DOI: 10.1002/pip.955

**Beschreibung**

Die vorliegende Erfindung betrifft ein Schichtsystem für Dünnschichtsolarzellen und ein Verfahren zur Herstellung eines Schichtsystems.

Dünnschichtsysteme für Solarzellen und Solarmodule sind hinreichend bekannt und in verschiedenen Ausführungen, je nach Substrat und aufgebrachten Materialien, auf dem Markt vorhanden. Die Materialien werden so gewählt, dass das einfallende Sonnenspektrum maximal ausgenutzt wird. Aufgrund der physikalischen Eigenschaften und der technologischen Handhabbarkeit sind Dünnschichtsysteme mit amorphen, mikromorphen oder polykristallinen Silizium, Cadmium-Tellurid (CdTe), Gallium-Arsenid (GaAs), Kupfer-Indium-(Gallium)-Selenid-Sulfid (Cu(In,Ga)(S,Se)$_2$), Kupfer-Zink-Zinn-Sulfo-Selenid (CZTS aus der Gruppe der Kesterite) sowie organischen Halbleitern besonders für Solarzellen geeignet. Der pentenäre Halbleiter Cu(In,Ga)(S,Se)$_2$ gehört zur Gruppe der Chalkopyrit-Halbleiter, die häufig als CIS (Kupferindiumdiselenid oder -sulfid) oder CIGS (Kupferindiumgalliumdiselenid, Kupferindiumgalliumdisulfid oder Kupferindiumgalliumdisulfoselenid) bezeichnet werden. S kann in der Abkürzung CIGS für Selen, Schwefel oder eine Mischung beider Chalkogene stehen.

Aktuelle Dünnschichtsolarzellen und Solarmodule auf Basis von Cu(In,Ga)(S,Se)$_2$ benötigen eine Pufferschicht zwischen einer p-leitenden Cu(In,Ga)(S,Se)$_2$-Absorberschicht und einer n-leitenden Frontelektrode. Die Frontelektrode enthält üblicherweise Zinkoxid (ZnO). Nach derzeitiger Erkenntnis ermöglicht diese Pufferschicht eine elektronische Anpassung zwischen Absorbermaterial und Frontelektrode. Sie bietet außerdem einen Schutz vor Sputterschäden im nachfolgenden Prozessschritt der Abscheidung der Frontelektrode durch DC-Magnetron-Sputtern. Zusätzlich verhindert sie den Stromabfluss von elektronisch gut-leitende in schlechtleitende Bereiche durch Aufbau einer hochohmigen Zwischenschicht zwischen p- und n-Halbleiter.

Bisher wurde am häufigsten Kadmiumsulfid (CdS) als Pufferschicht verwendet. Um gute Wirkungsgrade der Zelle erzeugen zu können, wurde Kadmiumsulfid bisher in einem chemischen Badprozess (CBD-Prozess) nasschemisch abgeschieden. Damit ist allerdings der Nachteil verbunden, dass der nasschemische Prozess nicht gut in den Prozessablauf der gegenwärtigen Produktion von Cu(In,Ga)(S,Se)$_2$-Dünnschichtsolarzellen passt.

Ein weiterer Nachteil der CdS-Pufferschicht besteht darin, dass sie das toxische Schwermetall Kadmium enthält. Dadurch entstehen höhere Produktionskosten, da erhöhte Sicherheitsvorkehrungen im Produktionsprozess getroffen werden müssen, beispielsweise bei der Entsorgung des Abwassers. Die Entsorgung des Produktes kann für den Kunden höhere Kosten verursachen, da der Hersteller je nach örtlicher Gesetzgebung zur Rücknahme, zur Entsorgung oder zum Recycling des Produktes gezwungen werden könnte. Die dadurch entstehenden Kosten würden an die Kunden weitergeben.

Es wurden daher verschiedene Alternativen zum Puffer aus Kadmiumsulfid für unterschiedliche Absorber aus der Familie der Cu(In,Ga)(S,Se)$_2$-Halbleiter getestet, beispielsweise gesputtertes ZnMgO, durch CBD abgeschiedenes Zn(S,OH), durch CBD abgeschiedenes In(O,OH) und Indiumsulfid, abgeschieden durch Atomic Layer Deposition (ALD), Ion Layer Gas Deposition (ILGAR), Sprühpyrolyse oder Physical Vapor Deposition (PVD)-Verfahren, wie thermisches Verdampfen oder Sputtern.

Allerdings eignen sich diese Materialien noch nicht als Puffer für Solarzellen auf Basis von Cu(In,Ga)(S,Se)$_2$ für eine kommerzielle Nutzung, da sie nicht die gleichen Wirkungsgrade erreichen, wie solche mit einer CdS-Pufferschicht. Der Wirkungsgrad beschreibt das Verhältnis von eingestrahlter Leistung zur erzeugten elektrischen Leistung einer Solarzelle und beträgt für CdS-Pufferschichten für Laborzellen auf kleinen Flächen bis etwa 20 % sowie für großflächige Module zwischen 10% und 15%. Weiterhin zeigen alternative Pufferschichten zu große Instabilitäten, Hystereseeffekte oder Degradationen im Wirkungsgrad, wenn sie Licht, Wärme und/oder Feuchte ausgesetzt sind.

Ein weiterer Nachteil von CdS-Pufferschichten liegt darin begründet, dass Kadmiumsulfid ein direkter Halbleiter mit einer direkten elektronischen Bandlücke von etwa 2,4 eV ist. Daher wird in einer Cu(In,Ga)(S,Se)$_2$/CdS/ZnO-Solarzelle schon bei CdS-Schichtdicken von einigen 10 nm das einfallende Licht in erheblichem Umfang absorbiert. Das in der Pufferschicht absorbierte Licht geht für die elektrische Ausbeute verloren, da die erzeugten Ladungsträger in dieser Schicht gleich wieder rekombinieren und es in diesem Bereich des Heteroübergangs und im Puffermaterial viele als Rekombinationszentren wirkende Kristalldefekte gibt. Als Folge wird der Wirkungsgrad der Solarzelle kleiner, was für eine Dünnschichtsolarzelle nachteilig ist.

Ein Schichtsystem mit einer Pufferschicht auf Basis von Indiumsulfid ist beispielsweise aus WO 2009/141132 A2 bekannt. Das Schichtsystem besteht aus einem Chalcopyrit-Absorber der CIGS-Familie und insbesondere aus Cu(In,Ga)(S,Se)$_2$ in Verbindung mit einer Pufferschicht aus Indiumsulfid. Die Indiumsulfid(In$_v$S$_w$)-Pufferschicht hat beispielsweise eine leicht indiumreiche Zusammensetzung mit $v/(v+w)$=41% bis 43%. Die Indiumsulfid-Pufferschicht kann mit verschiedenen nicht-nasschemischen Verfahren abgeschieden werden, beispielsweise durch thermisches Verdampfen, Elektronenstrahl-Verdampfen, Ion Layer Gas Reaction (ILGAR), Kathodenzerstäubung (Sputtern), Atomic Layer Deposition (ALD) oder Sprühpyrolyse.

In der bisherigen Entwicklung dieser Schichtsysteme und der Herstellungsverfahren hat sich jedoch gezeigt, dass der Wirkungsgrad von Solarzellen mit Indiumsulfid-Pufferschicht kleiner ist als der mit CdS-Pufferschichten.

Iver Lauermann et al.: "Synchrotron-based spectroscopy for the characterization of surfaces and interfaces in chalcopyrite thin-film solar cells", Solar Energy Materials And Solar Cells, Elsevier Science Publishers, Amsterdam, NL, Bd. 95, Nr. 6, 17. Dez. 2010, Seiten 1495-1508, zeigt ein Schichtsystem mit einer Na-haltigen Pufferschicht, wobei der Na-Gehalt außerhalb des in der vorliegenden Erfindung beanspruchten Bereichs liegt. Die in der Erfindung beanspruchten Bereiche sind mit der Anordnung von Lauermann et al. nicht erreichbar.

Bär M. et al.: "Deposition of In2S3 on Cu(In,Ga)(S,Se)2 thin film solar cell absorbers by spray ion layer gas reaction: Evidence of strong interfacial diffusion", Applied Physics Letters, AIP, American Institute of Physics, Melville, NY, US, Bd. 90, Nr. 13, 29. März 2007, Seiten 132118-1-132118-3, zeigt ein Schichtsystem mit einer Na-haltigen Pufferschicht, wobei der Na-Gehalt außerhalb des in der vorliegenden Erfindung beanspruchten Bereichs liegt. Die in der Erfindung beanspruchten Bereiche sind mit der Anordnung von Bär et al. nicht erreichbar.

Aufgabe der vorliegenden Erfindung ist es daher, ein Schichtsystem auf Basis eines Chalkogenidverbindungshalbleiters mit einer Pufferschicht bereitzustellen, das einen hohen Wirkungsgrad und hohe Stabilität aufweist, wobei die Herstellung kostengünstig und umweltverträglich sein soll.

Diese Aufgabe wird erfindungsgemäß durch ein Schichtsystem gemäß Anspruch 1 gelöst. Vorteilhafte Weiterbildungen der Erfindung ergeben sich aus den Unteransprüchen.

Des Weiteren umfasst die Erfindung ein Verfahren zur Herstellung eines Schichtsystems für Dünnschichtsolarzelle gemäß Anspruch 11.

Eine Verwendung des erfindungsgemäßen Schichtsystems geht aus weiterem Anspruch 14 hervor.

Das erfindungsgemäße Schichtsystem umfasst:

- eine Absorberschicht, die einen Chalkogenidverbindungshalbleiter enthält und
- eine Pufferschicht, die auf der Absorberschicht angeordnet ist,

wobei die Pufferschicht $Na_xIn_1S_yCl_z$ mit $0,05 \leq x < 0,2$ oder $0,2 < x \leq 0,5$, $1 \leq y \leq 2$ und $0,6 \leq x/z \leq 1,4$ enthält, wobei die Pufferschicht einen Anteil an Sauerstoff $\leq 10$ Atom-% und/oder einen Anteil an Kupfer $\leq 10$ Atom-% enthält, wobei die Pufferschicht Stoffmengenanteile an weiteren Elementen außer Natrium, Chlor, Indium, Schwefel, Sauerstoff und Kupfer von $\leq 1$ Atom-% enthält.

Im erfindungsgemäßen Schichtsystem ist für den Natriumgehalt der Wert x = 0,2 ausgenommen.

Wie Untersuchungen der Erfinder überraschenderweise ergaben, konnte durch Zugabe von Natrium und Chlor in eine Indiumsulfid-haltige Pufferschicht eine deutliche Erhöhung des Wirkungsgrads von Solarzellen gemessen werden.

Da die Elemente der Pufferschicht jeweils in verschiedenen Oxidationsstufen vorliegen können, werden im Folgenden alle Oxidationsstufen einheitlich mit dem Namen des Elements bezeichnet, sofern dies nicht explizit anders gekennzeichnet wird. Beispielsweise ist unter Natrium deshalb elementares Natrium, Natriumionen sowie Natrium in Verbindungen zu verstehen.

Der Index x gibt das Verhältnis der Stoffmenge von Natrium zur Stoffmenge von Indium in der Pufferschicht wieder und ist entscheidend für den Wirkungsgrad der Solarzelle. Eine deutliche Erhöhung des Wirkungsgrad im Vergleich zu reinen Indiumsulfid-Pufferschichten konnte bereits in einem Bereich von $0,05 \leq x \leq 0,5$ gemessen werden.

In einer vorteilhaften Ausgestaltung des erfindungsgemäßen Schichtsystems ist $0,1 \leq x < 0,2$ oder $0,2 < x \leq 0,3$. Für diese Werte konnten besonders hohe Wirkungsgrade von bis zu 15% gemessen werden.

Die optimale Menge an Natrium in der Pufferschicht liegt deutlich über der Gesamtmenge von Natrium in der Absorberschicht. Die Menge von Natrium in der Absorberschicht ist jedoch abhängig vom Herstellungsprozess. Natrium aus der Absorberschicht ist vergleichsweise mobil. Die Erfinder gehen davon aus, dass das gleichzeitige Angebot von Natrium und Chlor das Natrium in der Pufferschicht bindet. Die Anwesenheit von Natrium in der Pufferschicht verhindert gleichzeitig die Ausdiffusion von Natrium aus der Absorberschicht in die Pufferschicht.

Der Index y beträgt von 1 bis 2. Der Index y gibt das Verhältnis der Stoffmenge von Schwefel zur Stoffmenge von Indium wieder. In einer vorteilhaften Ausgestaltung des erfindungsgemäßen Schichtsystems ist $1,3 \leq y \leq 1,5$. Für diese Werte konnten besonders hohe Wirkungsgrade gemessen werden. Besonders hohe Wirkungsgrade konnten für Pufferschichten gemessen werden, die leicht indiumreich waren. Indiumreich bedeutet hier, dass der relative Anteil an Indium zu Schwefel größer als im stöchiometrischen Verhältnis von $In_2S_3$ ist und somit y < 1,5 gilt. In einer weiteren vorteilhaften Ausgestaltung der Erfindung ist die Pufferschicht amorph ausgebildet.

Das Verhältnis x/z beträgt von 0,6 bis 1,4 und bevorzugt von 0,8 bis 1,2. Für diese Werte konnten besonders hohe Wirkungsgrade gemessen werden. Wird Natrium und Chlor aus Natriumchlorid zugegeben, beträgt das Verhältnis x/z etwa 1. Geringfügig höhere Natriumanteile können sich beispielsweise durch Eindiffusion von Natrium aus der Absorberschicht oder einem Glassubstrat ergeben.

Für den Bereich von $0,05 \leq x \leq 0,5$ beträgt der Stoffmengenanteil an Natriumchlorid in der Pufferschicht ungefähr von 2 Atom-% bis 20 Atom-%. Beispielsweise beträgt der Stoffmengenanteil an Natriumchlorid in der Pufferschicht für x = 0,2, y = 1,4 und x/z = 1 etwa 7,1 Atom-%. Der Stoffmengenanteil in Atom-% bedeutet hier der Anteil der Stoffmenge eines Stoffs bezogen auf die Summe der Stoffmengen aller Elemente der Pufferschicht.

Eine vorteilhafte Ausgestaltung der erfindungsgemäßen Pufferschicht weist eine Schichtdicke von 10 nm bis 100 nm und bevorzugt von 20 nm bis 60 nm auf.

Die erfindungsgemäße Pufferschicht enthält einen Stoffmengenanteil an Sauerstoff von $\leq$ 10 Atom-%. Sauerstoff kann als Verunreinigung auftreten, da beispielhaft verwendete Materalen Indiumsulfid und Natriumchlorid hygroskopisch sind. Sauerstoff kann auch über Restwasserdampf aus den Beschichtungsanlagen eingeschleppt werden. Durch einen Stoffmengenanteil $\leq$ 10 Atom-% von Sauerstoff in der Pufferschicht kann ein hoher Wirkungsgrad der Solarzelle sichergestellt werden.

Die erfindungsgemäße Pufferschicht enthält einen Stoffmengenanteil an Kupfer von $\leq$ 10 Atom-%. Kupfer kann aus der Absorberschicht in die Pufferschicht eindiffundieren. Die Eindiffusion von größeren Mengen an Kupfer ist jedoch unvorteilhaft, da die Bandlücke der Pufferschicht durch Kupfer reduziert wird. Dies führt zu einer erhöhten Absorption des Lichtes in der Pufferschicht und damit zu einer Reduzierung des Wirkungsgrades. Wie Versuche der Erfinder gezeigt haben, führt die Verwendung von Natrium in der Pufferschicht zu einer vorteilhaften Hemmung der Eindiffusion von Kupfer in die Pufferschicht. Dies lässt sich dadurch erklären, dass Natrium und Kupfer im Indiumsulfid-Gitter die gleichen Plätze einnehmen und diese Plätze durch Natrium belegt sind. Durch einen Stoffmengenanteil von Kupfer in der Pufferschicht $\leq$ 10 Atom-% kann ein hoher Wirkungsgrad der Solarzelle sichergestellt werden.

In der erfindungsgemäßen Schichtstruktur weist die Pufferschicht keinen wesentlichen Anteil an weiteren Elementen außer Natrium, Chlor, Indium, Schwefel, Sauerstoff und Kupfer auf. Das bedeutet, dass die Pufferschicht nicht mit weiteren Elementen wie beispielsweise Kohlenstoff versehen ist und höchstens fertigungstechnisch nicht vermeidbare Stoffmengenanteile an weiteren Elementen von $\leq$ 1 Atom-% enthält. Dadurch lässt sich ein hoher Wirkungsgrad der Solarzelle sicherstellen.

In einer vorteilhaften Ausgestaltung des erfindungsgemäßen Schichtsystems weist der lokale Anteil an Natrium und Chlor in der Pufferschicht ein nichtkonstantes Tiefenprofil auf. Tiefenprofil im Sinne der vorliegenden Erfindung beschreibt die Richtung orthogonal zu den Schichten der Schichtstruktur, das bedeutet die Richtung parallel zur Dicke der einzelnen Schichten der Schichtstruktur. Insbesondere weist der Anteil an Natrium und Chlor in der Pufferschicht einen Gradienten auf, der von der der Absorberschicht zugewandten Oberfläche zum Inneren der Pufferschicht abfällt. Die Stoffmengenanteile der einzelnen Elemente in der gesamten Pufferschicht bleiben dabei im Rahmen der in der Erfindung beanspruchten Bereiche.

In einer vorteilhaften Ausgestaltung des erfindungsgemäßen Schichtsystems enthält die Absorberschicht als Chalkogenidverbindungshalbleiter $Cu_2ZnSn(S,Se)_4$ oder $Cu(In,Ga,Al)(S,Se)_2$ und bevorzugt $CuInSe_2$, $CuInS_2$, $Cu(In,Ga)Se_2$ oder $Cu(In,Ga)(S,Se)_2$. In einer weiteren vorteilhaften Ausgestaltung des erfindungsgemäßen Schichtsystems besteht die Absorberschicht im wesentlichen aus dem Chalkogenidverbindungshalbleiter $Cu_2ZnSn(S,Se)_4$ oder $Cu(In,Ga,Al)(S,Se)_2$ und bevorzugt aus $CuInSe_2$, $CuInS_2$, $Cu(In,Ga)Se_2$ oder $Cu(In,Ga)(S,Se)_2$.

Ein weiterer Aspekt der Erfindung umfasst Solarzellen, insbesondere Dünnschichtsolarzellen mit dem erfindungsgemäßen Schichtsystem sowie Solarzellenmodule, die diese Solarzellen beinhalten.

Eine erfindungsgemäße Dünnschichtsolarzelle umfasst mindestens:

- ein Substrat,
- eine Rückelektrode, die auf dem Substrat angeordnet ist,
- ein erfindungsgemäßes Schichtsystem, das auf der Rückelektrode angeordnet ist und
- eine Frontelektrode, die auf der zweiten Pufferschicht angeordnet ist.

Das Substrat ist vorzugsweise ein Metall-, Glas-, Kunststoff- oder Keramiksubstrat, wobei Glas bevorzugt wird. Es können aber auch andere transparente Trägermaterialien, insbesondere Kunststoffe verwendet werden.

Die Rückelektrode umfasst vorteilhafterweise Molybdän (Mo) oder andere Metalle. In einer vorteilhaften Ausgestaltung der Rückelektrode weist diese eine Molybdän-teilschicht auf, die an die Absorberschicht angrenzt, und eine Siliziumnitridteilschicht (SiN), die an die Molybdän-Teilschicht angrenzt. Derartige Rückelektrodensysteme sind beispielsweise aus EP 1356528 A1 bekannt.

Die Frontelektrode enthält bevorzugt ein transparentes leitendes Oxid (TCO), besonders bevorzugt Aluminium-, Gallium- oder Bor-dotiertes Zinkoxid und/oder Indium-Zinnoxid (ITO).

In einer vorteilhaften Ausgestaltung der erfindungsgemäßen Solarzelle ist zwischen der Pufferschicht und der Frontelektrode eine zweite Pufferschicht angeordnet. Die zweite Pufferschicht enthält bevorzugt undotiertes Zinkoxid und/oder undotiertes Zink-Magnesiumoxid.

Die Erfindung umfasst des Weiteren ein Verfahren zur Herstellung eines erfindungsgemäßen Schichtsystems, wobei zumindest

a) eine Absorberschicht bereitgestellt wird und
b) eine Pufferschicht auf der Absorberschicht angeordnet wird,

wobei die Pufferschicht $Na_xIn_1S_yCl_z$ mit $0{,}05 \leq x < 0{,}2$ oder $0{,}2 < x \leq 0{,}5$, $0{,}6 \leq x/z \leq 1{,}4$ und $1 \leq y \leq 2$ enthält, wobei die Pufferschicht einen Anteil an Sauerstoff $\leq$ 10 Atom-% und/oder einen Anteil an Kupfer $\leq$ 10 Atom-%

enthält, wobei die Pufferschicht Stoffmengenanteile an weiteren Elementen außer Natrium, Chlor, Indium, Schwefel, Sauerstoff und Kupfer von ≤ 1 Atom-% enthält.

Zweckmäßig wird die Absorberschicht in einem RTP-("rapid thermal processing") Prozess auf die Rückelektrode auf einem Substrat aufgebracht. Für Cu(In,Ga)(S,Se)$_2$-Absorberschichten wird dabei zunächst eine Vorläuferschicht auf das Substrat mit Rückelektrode abgeschieden. Die Vorläuferschicht enthält die Elemente Kupfer, Indium und Gallium, die durch Sputtern aufgebracht werden. Bei der Beschichtung durch die Vorläuferschicht wird eine gezielte Natriumdosis in die Vorläuferschicht eingebracht, wie beispielsweise aus EP 715 358 B1 bekannt ist. Des Weiteren enthält die Vorläuferschicht elementares Selen, das durch thermisches Verdampfen aufgebracht wird. Bei diesen Prozessen liegt die Substrattemperatur unter 100°C, so dass die Elemente im Wesentlichen als Metalllegierung und elementares Selen unreagiert erhalten blieben. Anschließend wird diese Vorläuferschicht in einem schnellen Temperverfahren (rapid thermal processing, RTP) in schwefelhaltiger Atmosphäre zu einem Cu(In,Ga)(S,Se)$_2$-Chalcopyrithalbleiter reagiert.

Zur Herstellung der Pufferschicht sind prinzipiell alle chemisch-physikalischen Abscheideverfahren geeignet, bei denen das Verhältnis von Natrium zu Chlor sowie das Verhältnis des Natriumchlorid-Anteils zum Indiumsulfid-Anteil gesteuert werden kann.

Die erfindungsgemäße Pufferschicht wird vorteilhafterweise durch Atomic Layer Deposition (ALD), Ion Layer Gas Deposition (ILGAR), Sprühpyrolyse, Chemical Vapour Deposition (CVD) oder Physical Vapor Deposition (PVD) auf die Absorberschicht aufgebracht. Die erfindungsgemäße Pufferschicht wird bevorzugt durch Sputtern (Kathodenzerstäubung), thermisches Verdampfen oder Elektronenstrahlverdampfen abgeschieden, besonders bevorzugt aus separaten Quellen für Natriumchlorid und Indiumsulfid. Indiumsulfid kann entweder aus getrennten Quellen für Indium und Schwefel verdampft werden oder aus einer Quelle mit einem In$_2$S$_3$-Verbindungshalbleitermaterial. Auch andere Indiumsulfide (In$_5$S$_6$/S$_7$ oder InS) sind in Kombination mit einer Schwefelquelle möglich.

Die erfindungsgemäße Pufferschicht wird vorteilhafterweise mit einem Vakuumverfahren abgeschieden. Das Vakuumverfahren hat den besonderen Vorteil, dass im Vakuum der Einbau von Sauerstoff oder Hydroxid verhindert wird. Hydroxid-Komponenten in der Pufferschicht sind vermutlich verantwortlich für Transienten des Wirkungsgrades bei Einwirkung von Wärme und Licht. Des Weiteren haben Vakuumverfahren den Vorteil, dass das Verfahren ohne Nasschemie auskommt und Standard-Vakuumbeschichtungsanlagen verwendet werden können.

In einer besonders vorteilhaften Ausführungsform des erfindungsgemäßen Verfahrens wird Natriumchlorid aus einer ersten Quelle und Indiumsulfid (In$_2$S$_3$) aus einer separaten, zweiten Quelle verdampft. Die Annordnung der Abscheidungsquellen ist bevorzugt derart gestaltet ist, dass sich die Dampfkeulen der Quellen überlappen. Dampfkeule im Sinne der vorliegenden Anmeldung bedeutet der Bereich vor dem Auslass der Quelle, welcher für die Abscheidung des verdampften Materials auf einem Substrat hinsichtlich Aufdampfrate und Homogenität technisch geeignet ist. Die Quelle ist beispielsweise eine Effusionszelle, ein Schiffchen oder Tiegel eines thermischen Verdampfers, einer Widerstandsheizung, eines Elektronenstrahlverdampfer oder eines Linearverdampfers.

In einer vorteilhaften Ausgestaltung des erfindungsgemäßen Verfahrens wird die Absorberschicht in einem In-Line-Verfahren oder in einem Rotations-Verfahren an Dampfkeulen von Natriumchlorid und Dampfkeulen von Indiumsulfid oder Indium und Schwefel vorbeigeführt wird. Die Dampfkeulen überlappen sich bevorzugt ganz oder teilweise.

In einer alternativen Ausführungsform des erfindungsgemäßen Verfahrens wird im zweiten Schritt b) zunächst eine Natriumchlorid-Verbindung auf der Absorberschicht abgeschieden. Beispielsweise wird Natriumchlorid aus einer Effusionszelle verdampft. Die verdampfte Menge an Natriumchlorid wird durch Öffnen und Schließen einer Blende oder durch eine Temperatursteuerung gesteuert. Anschließend wird in weiterer Schritt eine Pufferschicht aus Indiumsulfid, bevorzugt ohne Vakuumunterbrechung, auf der mit Natriumchlorid belegten Absorberschicht abgeschieden.

Ein weiterer Aspekt der Erfindung umfasst die Verwendung eines erfindungsgemäßen Schichtsystems in einer Dünnschichtsolarzelle oder einem Solarzellenmodul.

Die Erfindung wird nachfolgend anhand einer Zeichnung und eines Beispiels näher erläutert. Die Zeichnung ist nicht vollständig maßstabsgetreu. Die Erfindung wird durch die Zeichnung in keiner Weise eingeschränkt. Es zeigen:

Fig. 1   eine schematische Querschnittsansicht einer erfindungsgemäßen Dünnschichtsolarzelle mit erfindungsgemäßen Schichtsystem,

Fig.2   eine Messung des Wirkungsgrads an einem erfindungsgemäßen Schichtsystem mit Vergleichsbeispiel,

Fig. 3A   eine Messung des Wirkungsgrads an erfindungsgemäßen Schichtsystemen,

Fig. 3B   eine Messung der Leerlaufspannung an erfindungsgemäßen Schichtsystemen,

Fig. 4   eine Messung des Verhältnisses von Natrium zu Chlor an erfindungsgemäßen Pufferschichten,

Fig. 5   eine Messung des Verhältnisses von Natrium zu Chlor an erfindungsgemäßen Schichtsystemen,

Fig. 6   eine schematische Querschnittsansicht einer Weiterbildung eines erfindungsgemäßen Schichtsystems,

Fig. 7     ein Ausführungsbeispiel der erfindungsgemäßen Verfahrensschritte anhand eines Flussdiagramms,

Fig. 8     eine schematische Darstellung eines In-Line-Verfahrens zur Herstellung einer erfindungsgemäßen Pufferschicht und

Fig. 9     eine schematische Darstellung eines Rotations-Verfahrens zur Herstellung einer erfindungsgemäßen Pufferschicht.

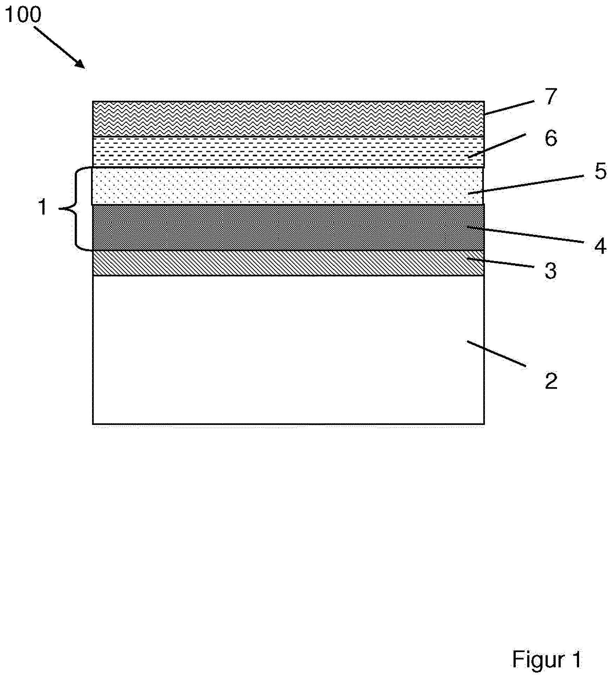

Figur 1 zeigt rein schematisch ein bevorzugtes Ausführungsbeispiel einer erfindungsgemäßen Dünnschichtsolarzelle 100 mit einem erfindungsgemäßen Schichtsystem 1 in einer Querschnittsansicht. Die Dünnschichtsolarzelle 100 enthält ein Substrat 2 und eine Rückelektrode 3. Auf der Rückelektrode 3 ist ein erfindungsgemäßes Schichtsystem 1 angeordnet. Das erfindungsgemäße Schichtsystem 1 umfasst eine Absorberschicht 4 und eine Pufferschicht 5. Auf dem Schichtsystem 1 ist eine zweite Pufferschicht 6 und eine Frontelektrode 7 angeordnet.

Das Substrat 2 besteht hier beispielsweise aus anorganischem Glas, wobei gleichermaßen andere isolierende Materialien mit genügender Festigkeit, sowie inertem Verhalten gegenüber den bei der Herstellung der Dünnschichtsolarzelle 100 durchgeführten Prozessschritten eingesetzt werden können, beispielsweise Kunststoffe, insbesondere Polymere oder Metalle, insbesondere Metall-Legierungen. In Abhängigkeit der Schichtdicke und den spezifischen Materialeigenschaften kann das Substrat 2 als starre Platte oder biegsame Folie ausgestaltet sein. Im vorliegenden Ausführungsbeispiel beträgt die Schichtdicke des Substrats 2 beispielsweise von 1 mm bis 5 mm.

Auf der lichteintrittsseitigen Oberfläche des Substrats 2 ist eine Rückelektrode 3 angeordnet. Die Rückelektrode 3 besteht beispielsweise aus einem lichtundurchlässigen Metall. Sie kann beispielsweise durch Aufdampfen oder magnetfeldunterstützte Kathodenzerstäubung auf dem Substrat 2 abgeschieden werden. Die Rückelektrode 3 besteht beispielsweise aus Molybdän (Mo), Aluminium (Al), Kupfer (Cu), Titan (Ti) oder aus einem Mehrschichtsystem mit einem solchen Metall, beispielsweise Molybdän (Mo). Die Schichtdicke der Rückelektrode 3 ist hier geringer als 1 $\mu$m, liegt vorzugsweise im Bereich von 300 nm bis 600 nm und beträgt beispielsweise 500 nm. Die Rückelektrode 3 dient als Rückseitenkontakt der Dünnschichtsolarzelle 100. Zwischen dem Substrat 2 und der Rückelektrode 3 kann eine Alkali-Barriere angeordnet sein, welche beispielsweise aus $Si_3N_4$, SiON oder SiCN besteht. Dies ist in Figur 1 nicht näher dargestellt.

Auf der Rückelektrode 3 ist ein erfindungsgemäßes Schichtsystem 1 angeordnet. Das Schichtsystem 1 enthält eine Absorberschicht 4, beispielsweise aus $Cu(In,Ga)(S,Se)_2$, die unmittelbar auf der Rückelektrode 3 aufgebracht ist. Die Absorberschicht 4 aus $Cu(In,Ga)(S,Se)_2$ wurde beispielsweise in dem eingangs beschriebenen RTP-Prozess abgeschieden. Die Absorberschicht 4 hat beispielsweise eine Dicke von 1,5 $\mu$m.

Auf der Absorberschicht 4 ist eine Pufferschicht 5 angeordnet. Die Pufferschicht 5 enthält beispielsweise $Na_xIn_1S_yCl_z$ mit $0,05 \leq x < 02$ oder $0,2 < x \leq 0,5$, $1,3 \leq y \leq 1,5$ und $0,6 \leq x/z < 1,4$ und beispielsweise $Na_{0,2}In_1S_{1,4}Cl_{0,2}$. Die Schichtdicke der Pufferschicht 5 beträgt von 20 nm bis 60 nm und beispielsweise 30 nm.

Oberhalb der Pufferschicht 5 kann eine zweite Pufferschicht 6 angeordnet sein. Die Pufferschicht 6 enthält beispielsweise undotiertes Zinkoxid (i-ZnO). Oberhalb der zweiten Pufferschicht 6 ist eine Frontelektrode 7 angeordnet, die als Vorderseitenkontakt dient und für Strahlung im sichtbaren Spektralbereich transparent ist ("Fensterschicht"). In der Regel wird für die Frontelektrode 7 ein dotiertes Metalloxid (TCO = Transparent Conductive Oxide) eingesetzt, beispielsweise n-leitendes, Aluminium (Al)-dotiertes Zinkoxid (ZnO), Bor (B)-dotiertes Zinkoxid (ZnO), oder Gallium (Ga)-dotiertes Zinkoxid (ZnO). Die Schichtdicke der Frontelektrode 7 beträgt beispielsweise etwa 300 bis 1500 nm. Zum Schutz vor Umwelteinflüssen kann auf der Frontelektrode 7 eine beispielsweise aus Polyvinylbutyral (PVB), Ethylenvinylacetat (EVA) oder DNP bestehende Kunststoffschicht (Verkapselungsfolie) aufgebracht sein. Zudem kann eine für Sonnenlicht transparente Deckplatte vorgesehen sein, die beispielsweise aus extraweißem Glas (Frontglas) mit geringem Eisengehalt besteht und eine Dicke von beispielsweise 1 bis 4 mm aufweist.

Der beschriebene Aufbau einer Dünnschichtsolarzelle oder eines Dünnschichtsolarmoduls ist dem Fachmann beispielsweise aus im Handel verfügbaren Dünnschichtsolarzellen oder Dünnschichtsolarmodulen wohlbekannt und wurde zudem bereits in zahlreichen Druckschriften der Patentliteratur eingehend beschrieben, beispielsweise in DE 19956735 B4.

In der in Figur 1 gezeigten Substratkonfiguration grenzt die Rückelektrode 3 an das Substrat 2 an. Es versteht sich, dass das Schichtsystem 1 gleichermaßen über eine Superstratkonfiguration verfügen kann, bei welcher das Substrat 2 transparent und die Frontelektrode 7 auf einer der Lichteintrittsseite abgewandten Oberfläche des Substrats 2 angeordnet ist.

Das Schichtsystem 1 kann zur Herstellung von integriert serienverschalteter Dünnschichtsolarzellen 100 dienen, wobei das Schichtsystem 1, die Rückelektrode 3 und die Frontelektrode 7 in an sich bekannter Weise durch verschiedene Strukturierungslinien ("P1" für Rückelektrode, "P2" für Kontakt Frontelektrode/Rückelektrode und "P3" für Trennung der Frontelektrode) strukturiert wird.

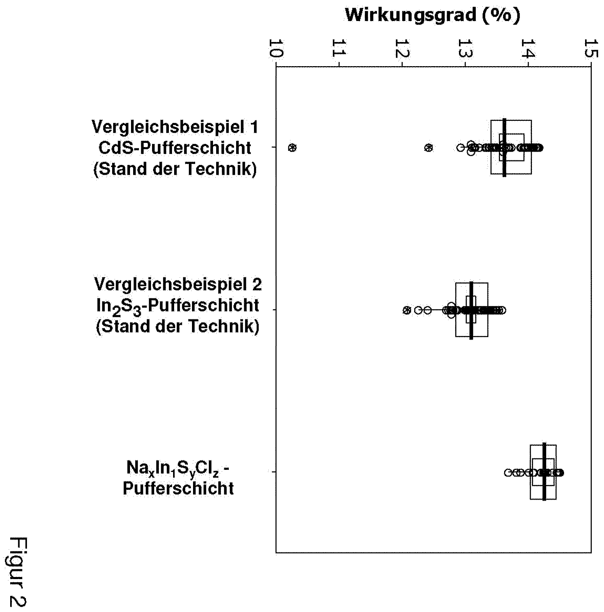

Figur 2 zeigt ein Diagramm des Wirkungsgrads von Dünnschichtsolarzellen 100 mit dem erfindungsgemäßen Schichtsystem 1 und zwei Vergleichsbeispielen nach dem Stand der Technik. Das erfindungsgemäße Beispiel enthält eine Dünnschichtsolarzelle 100 gemäß dem Aufbau aus Figur 1. Die Dünnschichtsolarzelle 100 enthält ein Substrat 2 aus Glas sowie eine Rückelektrode

3 aus einer $Si_3N_4$-Barriere-Schicht und einer Molybän-Schicht. Auf der Rückelektrode 3 ist eine Absorberschicht 4 aus $Cu(In,Ga)(S,Se)_2$ angeordnet, die nach dem oben beschriebenen RTP-Prozess abgeschieden wurde. Auf der Absorberschicht 4 ist eine $Na_xIn_1S_yCl_z$-Pufferschicht 5 angeordnet. Die Schichtdicke der Pufferschicht 5 beträgt 50 nm. Auf der Pufferschicht 5 ist eine 100 nm dicke zweite Pufferschicht 6 angeordnet, die undotiertes Zinkoxid enthält. Auf der zweiten Pufferschicht 6 ist eine 1200 nm dicke Frontelektrode 7 angeordnet, die n-leitendes Zinkoxid enthält. Die Fläche der Dünnschichtsolarzelle 100 beträgt 1,4 $cm^2$. Die Zellen mit der erfindungsgemäßen $Na_xIn_1S_yCl_z$-Pufferschicht wurden mit 6,5 Atom-% Natrium aus NaCl hergestellt. Das Verhältnis y der Stoffmengen von Schwefel und Indium betrug etwa 1,35. Das Verhältnis x der Stoffmengen von Natrium und Indium betrug etwa 0,18. Erfahrungsgemäß beträgt das Verhältnis x/z der Stoffmengen von Natrium und Chlor bei der Herstellung der Pufferschicht 5 aus Natriumchlorid etwa 1,0. Die Kennliniendaten der Dünnschichtsolarzelle 100 zeigen eine hohe Leerlaufspannung $V_{oc}$ von 582 mV und einen guten Füllfaktor FF von 70,8 %. Messungen ergaben einen mittleren Wirkungsgrad von 14,2 % und einen maximalen Wirkungsgrad von 14,5 %. Der mittlere Wirkungsgrad ist jeweils durch einen schwarzen Balken in Figur 2 dargestellt. Das Vergleichsbeispiel 1 enthält eine CdS-Pufferschicht nach dem Stand der Technik. Messungen am Vergleichsbeispiel 1 ergaben einen mittleren Wirkungsgrad von 13,6 % und einem maximalen Wirkungsgrad von 14,2 %. Das Vergleichsbeispiel 2 enthält eine Pufferschicht nach dem Stand der Technik aus Indiumsulfid mit einem Halogen-Gehalt von < 0,5 Atom-% als Verunreinigung aus dem Ausgangsmaterial. Messungen am Vergleichsbeispiel 2 ergaben einen mittleren Wirkungsgrad von 13,1 % und einem maximalen Wirkungsgrad von 13,6 %. Figur 2 zeigt, dass das erfindungsgemäße Beispiel einen deutlich höheren maximalen Wirkungsgrad und einen deutlich höheren mittleren Wirkungsgrad aufweist als die Vergleichsbeispiele 1 und 2 nach dem Stand der Technik.

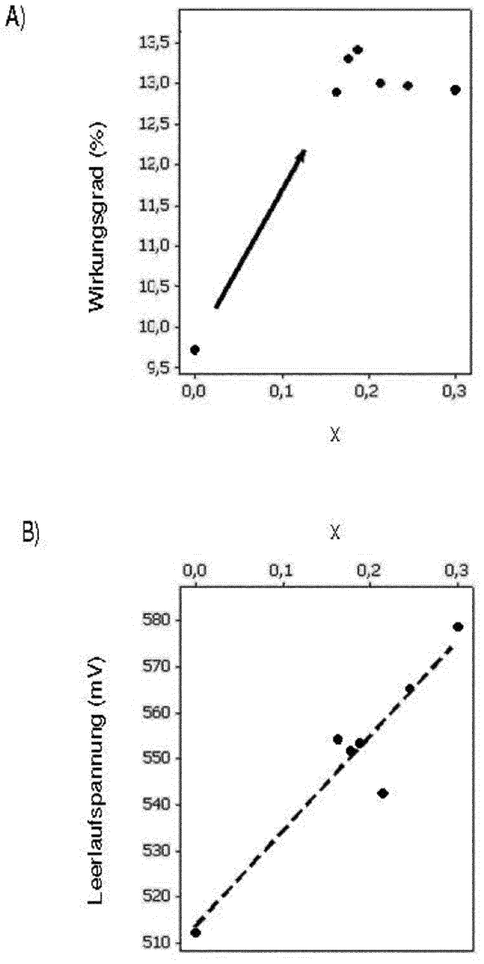

Figur 3 A zeigt Messungen des Wirkungsgrads und Figur 3 B Messungen der Leerlaufspannung in Abhängigkeit des Index x, also in Abhängigkeit des Verhältnisses der Stoffmengen von Natrium und Indium. Als Vergleichbeispiel dient die Messung bei x = 0 an einer Schichtstruktur nach dem Stand der Technik, die kein Natrium in der Pufferschicht 5 enthält. Der Wirkungsgrad des Vergleichsbeispiels beträgt etwa 9,7 % und die Leerlaufspannung etwa 512 mV. Für erfindungsgemäße Schichtstrukturen 1 mit $0,1 \leq x < 0,2$ und $0,2 < x \leq 0,3$ konnten unerwarteterweise deutlich höhere Wirkungsgrade im Bereich von 12,9 % bis 13,4 % und deutlich höhere Leerlaufspannungen im Bereich von 540 mV bis 578 mV gemessen werden. Die erfindungsgemäßen Schichtstrukturen 1 zeigten deutlich höhere Wirkungsgrade als das Vergleichsbeispiel.

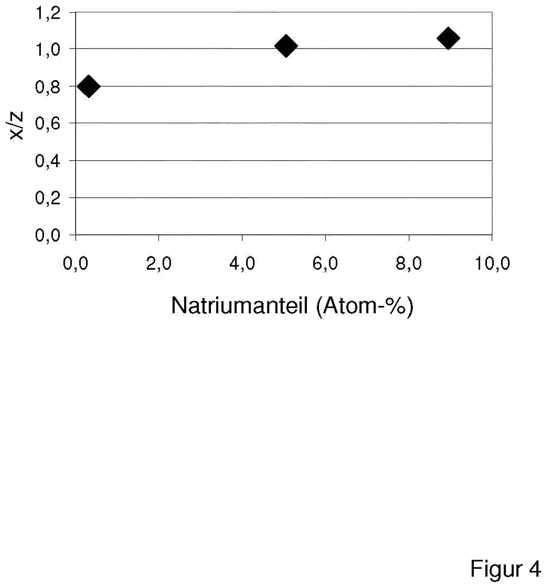

Figur 4 zeigt eine Messung des Verhältnisses x/z der Stoffmengen von Natrium zu Chlor durch Rutherford-Back-Scattering (RBS). Zur Analyse des Verhältnisses wurden dünne Pufferschichten mit einer Schichtdicke von etwa 40 nm durch Koverdampfen von Indiumsulfid mit Natriumchlorid hergestellt. Das Verhältnis x/z ist über dem Stoffmengenanteil von Natrium in der Pufferschicht 5 in Atom-% aufgetragen. Für eine große Variationsbreite im Stoffmengenanteil von Natrium von 0,3 Atom-% bis 9 Atom-% ändert sich das Verhältnis x/z nur wenig. So beträgt das Verhältnis x/z für einen Natriumanteil von 5 Atom-% etwa 1,01 und für einen Natriumanteil von 9 Atom-% etwa 1,06. Es lässt sich folgern, dass durch Verdampfen von Natriumchlorid das Natrium und das Chlor im Indiumsulfid nahezu im gleichen Verhältnis eingebaut werden wie im Ausgangsmaterial Natriumchlorid. Die Abweichungen des Verhältnisses x/z vom Wert 1 kann durch Mess- oder Präparationsfehler verursacht sein, insbesondere da die Schichten hygroskopisch und mit etwa 40 nm sehr dünn sind.

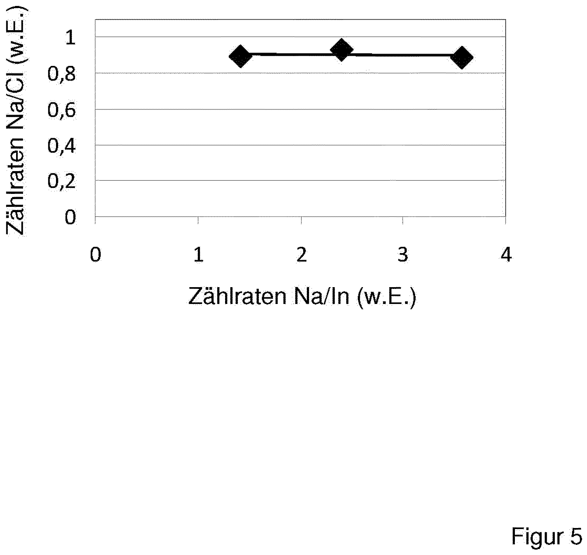

Figur 5 zeigt das Verhältnis von Natrium zu Chlor für verschiedene Mengen Natrium in einer erfindungsgemäßen Dünnschichtsolarzelle 100. Dazu wurden Dünnschichtsolarzellen 100 mit Molybdän-Rückelektrode 3, $Cu(In,Ga)(S,Se)_2$-Absorberschicht 4, $Na_xIn_1S_yCl_z$-Pufferschicht 5 und ZnO-Frontelektrode 7 hergestellt, wobei die Natriummenge in der Pufferschicht 5 variiert wurde. Anschließend wurde die Dünnschichtsolarzellen 100 mit Sekundärionen-Massenspektrometrie (SIMS) untersucht. Dabei wurden die Elementprofile durch die ganze Zelle aufgenommen und die Zählraten integriert. Auf der vertikalen Achse ist das SIMS-Zählratenverhältnis für Natrium/Chlor aufgetragen. Auf der horizontalen Achse ist die Natriumzählrate, abzüglich der Natriummenge der Absorberschicht 4 aufgetragen. Figur 5 zeigt ein nahezu konstantes Zählratenverhältnis von Natrium/Chlor für verschiedene eingebrachte Mengen an Natrium. Das Verhältnis von Natrium und Chlor ist im Rahmen der Messgenauigkeit konstant und unabhängig von dem eingebrachten Natriumanteil. Dies lässt sich dadurch erklären, da der Natrium-Anteil in der Absorberschicht 4 klein im Vergleich zum Natrium-Anteil in der Pufferschicht 5 ist und keine oder nur geringe Mengen Natrium aus der Absorberschicht 4 oder dem Substrat 2 in die Pufferschicht 5 eindiffundieren. Gleichzeitig findet keine oder eine nur geringe Wegdiffusion von Natrium aus der Pufferschicht 5 statt. Der in Figur 5 aufgetragene Verhältniswert ist hier kein Stoffmengenverhältnis und in willkürlichen Einheiten aufgetragen, da die Zählraten nicht kalibriert sind.

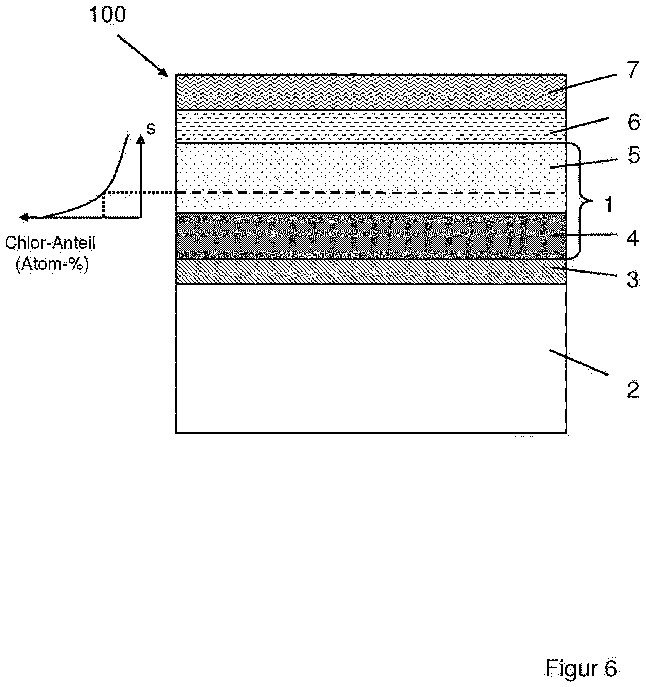

Figur 6 zeigt eine alternative Ausgestaltung einer erfindungsgemäßen Dünnschichtsolarzelle 100 mit einer erfindungsgemäßen Schichtstruktur 1. Substrat 2, Rückelektrode 3, Absorberschicht 4, zweite Pufferschicht 6 und Frontelektrode 7 entsprechen den Ausführungen unter Figur 1. Die Pufferschicht 5 weist dabei einen Gradienten im Chlor-Anteil über die Schichttiefe s der Pufferschicht 5 auf. Der Chlor-Anteil beschreibt den Anteil aller in der Pufferschicht 5 vorhandenen Chloratome unabhängig von ihrer Oxidationsstufe.

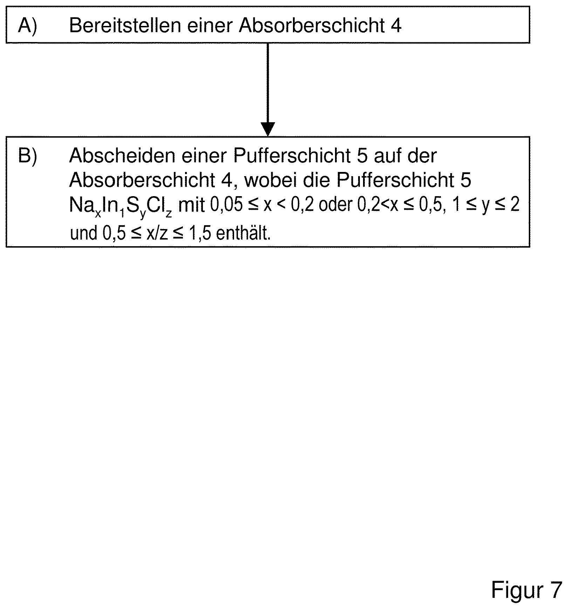

Figur 7 zeigt ein Flussdiagramm eines erfindungsgemäßen Verfahrens. In einem ersten Schritt wird eine Absorberschicht 4 beispielsweise aus einem Cu(In,Ga)(S,Se)$_2$-Halbleitermaterial bereitgestellt. In einem zweiten Schritt wird die Pufferschicht 5 aus Natrium und Chlor, beispielsweise aus Natriumchlorid, und Indiumsulfid abgeschieden. Das Verhältnis der einzelnen Komponenten in der Pufferschicht 5 wird beispielsweise durch eine Steuerung der Aufdampfrate geregelt, beispielsweise durch eine Blende oder eine Temperatursteuerung.

In weiteren Prozessschritten kann eine zweite Pufferschicht 6 und eine Frontelektrode 7 auf der Pufferschicht 5 abgeschieden werden. Des Weiteren kann eine Verschaltung und Kontaktierung der Schichtstruktur 1 zu einer Dünnschichtsolarzelle 100 oder einem Solarmodul erfolgen.

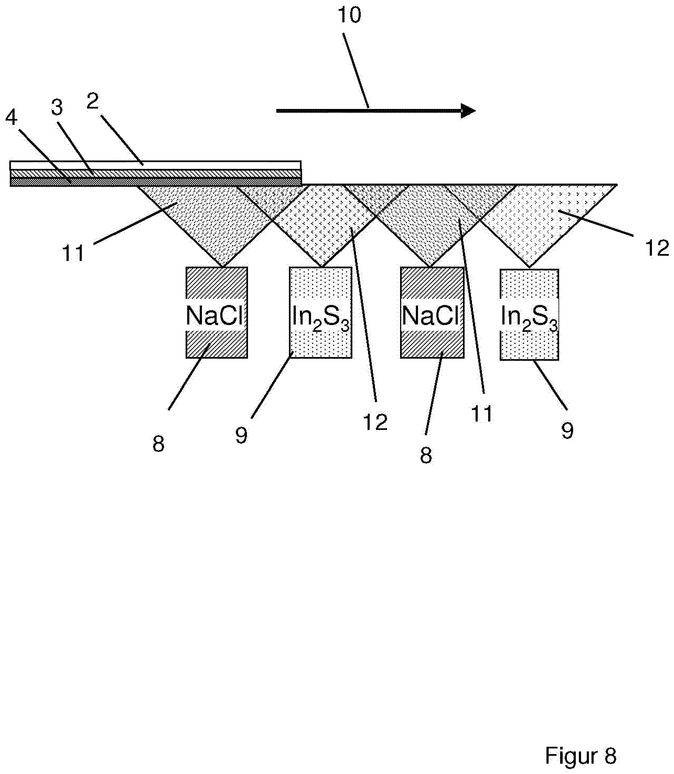

Figur 8 zeigt eine schematische Darstellung eines In-Line-Verfahrens zur Herstellung einer erfindungsgemäßen Pufferschicht 5 aus Na$_x$In$_1$S$_y$Cl$_z$. Das Substrat 2 mit Rückelektrode 3 und Absorberschicht 4 wird in einem In-Line-Verfahren an den Dampfkeulen 11,12 von beispielsweise zwei Natriumchlorid-Quellen 8 und zwei Indiumsulfid-Quellen 9 vorbeigeführt. Die Transportrichtung ist durch einen Pfeil mit dem Bezugszeichen 10 angegeben. Die Quellen 8,9 sind alternierend angeordnet, wobei sich die Dampfkeulen 11 der Natriumchlorid-Quellen 8 und die Dampfkeulen 12 der Indiumsulfid-Quellen 9 überlappen. Auf diese Weise wird die Absorberschicht 4 mit mehreren dünnen Schichten Natriumchlorid und Indiumsulfid beschichtet, die sich vermischen. Die Natriumchlorid-Quelle 8 und die Indiumsulfid-Quelle 9 sind beispielsweise Effusionszellen, aus denen Natriumchlorid beziehungsweise Indiumsulfid thermisch verdampft wird. Alternativ ist jede andere Form der Erzeugung von Dampfkeulen 11,12 zur Abscheidung der Pufferschicht 5 geeignet, sofern sich das Verhältnis der Stoffmengenanteile von Natrium, Chlor, Indium und Schwefel steuern lässt. Alternative Quellen sind beispielsweise Schiffchen von Linearverdampfern oder Tiegel von Elektronenstrahlverdampfern.

In einer alternativen Vorrichtung zur Durchführung des erfindungsgemäßen Verfahrens sind mehrere Quellen von Natriumchlorid 8 und Indiumsulfid 9 zweidimensional alternierend angeordnet, beispielsweise in einer Schachbrettmusteranordnung.

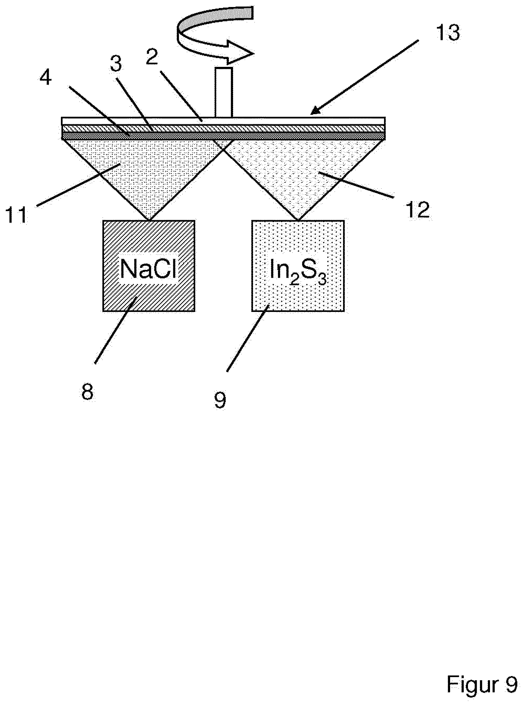

Figur 9 zeigt eine weitere alternative Ausführungsform des erfindungsgemäßen Verfahrens am Beispiel eines Rotations-Verfahrens. Das Substrat 2 mit Rückelektrode 3 und Absorberschicht 4 ist auf einem drehbaren Probenträger 13 angeordnet, beispielsweise auf einem Probenkarussell. Unterhalb des Probenträgers 13 befinden sich alternierend angeordnete Quellen von Natriumchlorid 8 und Indiumsulfid 9. Während der Abscheidung der erfindungsgemäßen Pufferschicht 5 wird der Probenträger 13 gedreht. Dadurch wird das Substrat 2 in den Dampfkeulen 11,12 bewegt und beschichtet.

Sowohl im Laborprozess mit rotierendem Substrat 2 auf einem drehbaren Probenträger 13 als auch im industriellen In-Line-Verfahren mit linearem Vorschub des Substrats 2 unter Verdampferquellen mit Natriumchlorid 8 und Indiumsulfid 9 können die Verdampfungsraten und die Anordnung der Quellen 8,9 so gewählt werden, dass die Absorberschicht 4 zuerst mit einem erhöhten Anteil an Natriumchlorid beschichtet wird. Das kann zur Ausbildung eines vorteilhaften Chlor-Gradienten in der Pufferschicht 5 an der Grenzfläche zur Absorberschicht 4 führen, wie in Figur 6 dargestellt ist.

Das Einbringen von Natrium und Chlor aus Natriumchlorid in die Indiumsulfid-Pufferschicht 5 hat mehrere besondere Vorteile. Natriumchlorid ist nicht-toxisch und kostengünstig und kann, wie bereits erwähnt, leicht über thermische Verfahren aufgebracht werden. Beim thermischen Verdampfen verdampft Natriumchlorid als NaCl-Molekül und dissoziiert nicht zu Natrium und Chlor. Dies hat den besonderen Vorteil, dass während des Verdampfens kein giftiges und korrosives Chlor entsteht.

Das Einbringen von Natrium und Chlor aus Natriumchlorid bietet zusätzliche produktionstechnische Vorteile. Es muss nur ein Stoff aufgedampft werden, was den Prozess im Gegensatz zu möglichen Stoffmischungen wie NaCl/In$_2$S$_3$ stark vereinfacht. So ist die Dampfdruckkurve von Natrium beispielsweise aus C.T. Ewing, K.H. Stern, "Equilibrium Vaporization Rates and Vapor Pressures of Solid and Liquid Sodium Chloride, Potassium Chloride, Potassium Bromide, Cesium Iodide, and Lithium Fluoride", J. Phys. Chem., 1974, 78, 20, 1998-2005 bekannt und ein thermischer Verdampfungsprozess kann leicht über die Temperatur gesteuert werden. Des Weiteren lässt sich eine Anordnung zur Verdampfung von Natriumchlorid leicht in bestehende thermische Indiumsulfid-Beschichtungsanlagen integrieren.

Aus den vorstehenden Ausführungen ist klar geworden, dass durch die vorliegende Erfindung die Nachteile von bisher verwendeten CdS-Pufferschichten beziehungsweise den alternativen Pufferschichten bei Dünnschichtsolarzellen überwunden werden konnte, wobei der Wirkungsgrad und die Stabilität der damit erzeugten Dünnschichtsolarzellen ebenfalls sehr gut oder besser ist. Gleichzeitig ist das Herstellungsverfahren kostengünstig, effektiv und umweltschonend.

Es hat sich gezeigt, dass mit dem erfindungsgemäßen Schichtsystem vergleichbar gute Solarzellencharakteristika erreicht werden können, wie sie bei herkömmlichen CdS-Pufferschichten vorliegen. Mit dem erfindungsgemäßen Aufbau konnten hohe Wirkungsgrade bis zu 14,5 % erreicht werden. Dies war für den Fachmann unerwartet und überraschend.


Bezugszeichen


1    Schichtsystem
2    Substrat

3    Rückelektrode
4    Absorberschicht
5    Pufferschicht
6    zweite Pufferschicht
7    Frontelektrode
8    Natriumchlorid-Quelle
9    Indiumsulfid-Quelle
10   Transportrichtung
11   Natriumchlorid-Dampfkeule
12   Indiumsulfid-Dampfkeule
13   Probenträger
100  Dünnschichtsolarzelle
s    Schichttiefe

**Patentansprüche**

1.  Schichtsystem (1) für Dünnschichtsolarzellen (100), umfassend:

    - eine Absorberschicht (4), die einen Chalkogenidverbindungshalbleiter enthält,
    - eine Pufferschicht (5), die auf der Absorberschicht (4) angeordnet ist, wobei die Pufferschicht (5) $Na_xIn_1S_yCl_z$ mit

    $$0,05 \leq x < 0,2 \text{ oder } 0,2 < x \leq 0,5,$$

    $$0,6 \leq x/z \leq 1,4$$

    und

    $$1 \leq y \leq 2$$

    enthält,

    wobei die Pufferschicht (5) einen Anteil an Sauerstoff $\leq 10$ Atom-% und/oder einen Anteil an Kupfer $\leq 10$ Atom-% enthält, wobei die Pufferschicht (5) Stoffmengenanteile an weiteren Elementen außer Natrium, Chlor, Indium, Schwefel, Sauerstoff und Kupfer von $\leq 1$ Atom-% enthält.

2.  Schichtsystem (1) nach Anspruch 1, wobei $0,1 \leq x < 0,2$ oder $0,2 < x \leq 0,3$ beträgt.

3.  Schichtsystem (1) nach Anspruch 1 oder Anspruch 2, wobei $0,8 \leq x/z \leq 1,2$ beträgt.

4.  Schichtsystem (1) nach einem der Ansprüche 1 bis 3, wobei $1,3 \leq y \leq 1,5$ beträgt

5.  Schichtsystem (1) nach einem der Ansprüche 1 bis 4, wobei die Pufferschicht (5) eine Schichtdicke von 10 nm bis 100 nm aufweist.

6.  Schichtsystem (1) nach einem der Ansprüche 1 bis 5, wobei der Anteil an Natrium und Chlor in der Pufferschicht (5) ein nichtkonstantes Tiefenprofil aufweist.

7.  Schichtsystem (1) nach Anspruch 6, wobei der Stoffmengenanteil an Natrium und Chlor in der Pufferschicht (5) einen von der der Absorberschicht (4) zugewandten Oberfläche zum Inneren der Pufferschicht (5) abfallenden Gradienten aufweist.

8.  Schichtsystem (1) nach einem der Ansprüche 1 bis 7, wobei der Chalkogenidverbindungshalbleiter $Cu_2ZnSn(S,Se)_4$ oder $Cu(In,Ga,Al)(S,Se)_2$ enthält.

9.  Dünnschichtsolarzelle (100), mindestens umfassend:

    - ein Substrat (2),
    - eine Rückelektrode (3), die auf dem Substrat (2) angeordnet ist,
    - ein Schichtsystem (1) nach einem der Ansprüche 1 bis 8, das auf der Rückelektrode (3) angeordnet ist und
    - eine Frontelektrode (7), die auf dem Schichtsystem (1) angeordnet ist.

10. Dünnschichtsolarzelle (100) nach Anspruch 9, wobei zwischen der Pufferschicht (5) und der Frontelektrode (7) eine zweite Pufferschicht (6) angeordnet ist.

11. Verfahren zur Herstellung eines Schichtsystems (1) für Dünnschichtsolarzellen (100), wobei zumindest

    a) eine Absorberschicht (4), die einen Chalkogenidverbindungshalbleiter enthält, bereitgestellt wird und
    b) eine Pufferschicht (5) auf der Absorberschicht (4) angeordnet wird, wobei die Pufferschicht (5) $Na_xIn_1S_yCl_z$ mit

    $$0,05 \leq x < 0,2 \text{ oder } 0,2 < x \leq 0,5,$$

    $$0,6 \leq x/z \leq 1,4$$

    und

    $$1 \leq y \leq 2$$

    enthält,

wobei die Pufferschicht (5) einen Anteil an Sauerstoff ≤ 10 Atom-% und/oder einen Anteil an Kupfer ≤ 10 Atom-% enthält,
wobei die Pufferschicht (5) Stoffmengenanteile an weiteren Elementen außer Natrium, Chlor, Indium, Schwefel, Sauerstoff und Kupfer von ≤ 1 Atom-% enthält.

**12.** Verfahren nach Anspruch 11, wobei im Schritt b) Natriumchlorid und Indiumsulfid auf die Absorberschicht (4) aufgebracht wird durch Atomic Layer Deposition (ALD), Ion Layer Gas Deposition (ILGAR), Sprühpyrolyse, Chemical Vapour Deposition (CVD) oder Physical Vapor Deposition (PVD), Sputtern, thermisches Verdampfen oder Elektronenstrahlverdampfen.

**13.** Verfahren nach Anspruch 11 oder Anspruch 12, wobei die Absorberschicht (4) in einem In-Line-Verfahren oder in einem Rotations-Verfahren an mindestens einer Dampfkeule von Natriumchlorid (11) und mindestens einer Dampfkeule von Indiumsulfid (12) vorbeigeführt wird.

**14.** Verwendung eines Schichtsystems (1) nach einem der Ansprüche 1 bis 8 in einer Dünnschichtsolarzelle (100) oder einem Solarzellenmodul.

## Claims

**1.** Layer system (1) for thin-film solar cells (100), comprising:

- an absorber layer (4) that contains a chalcogenide compound semiconductor,
- a buffer layer (5) that is arranged on the absorber layer (4), wherein the buffer layer (5) contains $Na_xIn_1S_yCl_z$ with

$$0.05 \leq x < 0.2 \text{ or } 0.2 < x \leq 0.5,$$

$$0.6 \leq x/z \leq 1.4,$$

and

$$1 \leq y \leq 2$$

wherein the buffer layer (5) contains a fraction of oxygen ≤ 10 atom-% and/or a fraction of copper ≤ 10 atom-%,
wherein the buffer layer (5) contains mole fractions of other elements besides sodium, chlorine, indium, sulfur, oxygen, and copper of ≤ 1 atom-%.

**2.** Layer system (1) according to claim 1, wherein 0.1 ≤ x < 0.2 or 0.2 < x ≤ 0.3.

**3.** Layer system (1) according to claim 1 or claim 2, wherein 0.8 ≤ x/z ≤ 1.2.

**4.** Layer system (1) according to one of claims 1 through 3, wherein 1.3 ≤ y ≤ 1.5.

**5.** Layer system (1) according to one of claims 1 through 4, wherein the buffer layer (5) has a layer thickness from 10 nm to 100 nm.

**6.** Layer system (1) according to one of claims 1 through 5, wherein the fraction of sodium and chlorine in the buffer layer (5) has a non-constant depth profile.

**7.** Layer system (1) according to claim 6, wherein the mole fraction of sodium and chlorine in the buffer layer (5) has a decreasing gradient from the surface facing the absorber layer (4) to the interior of the buffer layer (5).

**8.** Layer system (1) according to one of claims 1 through 7, wherein the chalcogenide compound semiconductor contains $Cu_2ZnSn(S,Se)_4$, or $Cu(In,Ga,Al)(S,Se)_2$.

**9.** Thin-film solar cell (100), comprising:

- a substrate (2),
- a rear electrode (3) that is arranged on the substrate (2),
- a layer system (1) according to one of claims 1 through 8, that is arranged on the rear electrode (3), and
- a front electrode (7) that is arranged on the layer system (1).

**10.** Thin-film solar cell (100) according to claim 9, wherein a second buffer layer (6) is arranged between the buffer layer (5) and the front electrode (7).

**11.** Method for producing a layer system (1) for thin-film solar cells (100), wherein

a) an absorber layer (4) that contains a chalcogenide compound semiconductor is prepared and
b) a buffer layer (5) is arranged on the absorber layer (4),
wherein the buffer layer (5) contains $Na_xIn_1S_yCl_z$ with

$$0.05 \leq x < 0.2 \text{ or } 0.2 < x \leq 0.5,$$

$$0.6 \leq x/z \leq 1.4$$

and

$$1 \leq y \leq 2$$

wherein the buffer layer (5) contains a fraction of oxygen $\leq 10$ atom-% and/or a fraction of copper $\leq 10$ atom-%, wherein the buffer layer (5) contains mole fractions of other elements besides sodium, chlorine, indium, sulfur, oxygen, and copper of $\leq 1$ atom-%.

**12.** Method according to claim 11, wherein in the step b) sodium chloride and indium sulfide are applied on the absorber layer (4) by atomic layer deposition (ALD), ion layer gas deposition (ILGAR), spray pyrolysis, chemical vapor deposition (CVD) or physical vapor deposition (PVD), sputtering, thermal deposition, or electron beam deposition.

**13.** Method according to claim 11 or claim 12, wherein the absorber layer (4) is conveyed past at least one steam beam of sodium chloride (11) and at least one steam beam of indium sulfide (12) in an in-line method or a rotation method.

**14.** Use of a layer systems (1) according to one of claims 1 through 8 in a thin-film solar cell (100) or a solar cell module.

## Revendications

**1.** Système de stratifié (1) pour cellules solaires à couches minces (100), comprenant :

- une couche d'absorption (4) qui contient un semi-conducteur composé de chalcogénure,
- une couche tampon (5) disposée sur la couche d'absorption (4), où la couche tampon (5) contient du $Na_xIn_1S_yCl_z$ avec

$$0.05 \leq X < 0.2 \text{ ou } 0.2 < x \leq 0.5,$$

$$0.6 \leq x/z \leq 1.4$$

et

$$1 \leq y \leq 2$$

où la couche tampon (5) contient une teneur en oxygène de $\leq 10\%$ at. et/ou une teneur en cuivre de $\leq 10\%$ at., où la couche tampon (5) contient une fraction molaire de substances d'autres éléments autres que le sodium, le chlore, l'indium, le soufre, l'oxygène et le cuivre de $\leq 1\%$ at.

**2.** Système de stratifié (1) selon la revendication 1, où $0,1 \leq x < 0,2$ ou $0,2 < x \leq 0,3$.

**3.** Système de stratifié (1) selon la revendication 1 ou la revendication 2, où $0,8 \leq x/z \leq 1,2$.

**4.** Système de stratifié (1) selon l'une quelconque des revendications 1 à 3, où $1,3 \leq y \leq 1,5$.

**5.** Système de stratifié (1) selon l'une quelconque des revendications 1 à 4, où la couche tampon (5) a une épaisseur de couche de 10 nm à 100 nm.

**6.** Système de stratifié (1) selon l'une des revendications 1 à 5, où la teneur en sodium et en chlore dans la couche tampon (5) présente un profil de profondeur non constant.

**7.** Système de stratifié (1) selon la revendication 6, où la fraction molaire de sodium et de chlore dans la couche tampon (5) présente un gradient qui tombe depuis la surface tournée vers la couche d'absorption (4) vers l'intérieur de la couche tampon (5).

**8.** Système de stratifié (1) selon l'une quelconque des revendications 1 à 7, où le semi-conducteur composé de chalcogénure contient du $Cu_2ZnSn(S,Se)_4$ ou du $Cu(In,Ga,Al)(S,Se)_2$.

**9.** Cellule solaire à film mince (100), comprenant au moins:

- un substrat (2),
- une électrode arrière (3) disposée sur le substrat (2),
- un système de stratifié (1) selon l'une quelconque des revendications 1 à 8, qui est disposée sur l'électrode arrière (3) et
- une électrode avant (7) disposée sur le système de stratifié (1).

**10.** Cellule solaire à film mince (100) selon la revendication 9, où une deuxième couche tampon (6) est disposée entre la couche tampon (5) et l'électrode avant (7).

11. Procédé pour la production d'un système de stratifié (1) pour les cellules solaires à couches minces (100), où au moins

   a) une couche d'absorption(4) qui contient un semi-conducteur composé de chalcogénure est fournie;
   b) une couche tampon (5) est disposée sur la couche d'absorption (4),
   où la couche tampon (5) contient du $Na_xIn_1S_yCl_z$ avec

$$0,05 \leq X < 0,2 \text{ ou } 0,2 < x \leq 0,5,$$

$$0,6 \leq x/z \leq 1,4$$

et

$$1 \leq y \leq 2$$

   où la couche tampon (5) contient une teneur en oxygène de $\leq 10\%$ at. et/ou une teneur en cuivre de $\leq 10\%$ at.,
   où la couche tampon (5) contient une fraction molaire de substances d'autres éléments autres que le sodium, le chlore, l'indium, le soufre, l'oxygène et le cuivre de $\leq 1\%$ at.

12. Procédé selon la revendication 11, où à l'étape b) du chlorure de sodium et du sulfure d'indium est appliqué à la couche d'absorption (4) par le dépôt de couche atomique (ALD), le dépôt gazeux par couche ionique (ILGAR), la pyrolyse par pulvérisation, le dépôt chimique en phase gazeuse (CVD) ou le dépôt physique en phase vapeur (PVD), la pulvérisation, l'évaporation thermique ou l'évaporation par faisceau d'électrons.

13. Procédé selon la revendication 11 ou la revendication 12, où la couche d'absorption (4) est conduite devant au moins un lobe de chlorure de sodium (11) et au moins un lobe de vapeur de sulfure d'indium (12) dans un processus en ligne ou dans un processus de rotation

14. L'utilisation d'un système de stratifié (1) selon l'une quelconque des revendications 1 à 8 dans une cellule solaire à couches minces (100) ou un module de cellules solaires.

100

7

6

5

1

4

3

2

Figur 1

Figur 2

A)

B)

Figur 4

Figur 5

100

s

Chlor-Anteil
(Atom-%)

7

6

5

1

4

3

2

Figur 6

A)      Bereitstellen einer Absorberschicht 4

B)      Abscheiden einer Pufferschicht 5 auf der Absorberschicht 4, wobei die Pufferschicht 5 $Na_xIn_1S_yCl_z$ mit $0{,}05 \leq x < 0{,}2$ oder $0{,}2 < x \leq 0{,}5$, $1 \leq y \leq 2$ und $0{,}5 \leq x/z \leq 1{,}5$ enthält.

Figur 7

Figur 8

Figur 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2009141132 A2
- EP 1356528 A1
- EP 715358 B1
- DE 19956735 B4

**In der Beschreibung aufgeführte Nicht-Patentliteratur**

- Synchrotron-based spectroscopy for the characterization of surfaces and interfaces in chalcopyrite thin-film solar cells. **IVER LAUERMANN et al.** Solar Energy Materials And Solar Cells. Elsevier Science Publishers, Dezember 2010, vol. 95, 1495-1508

- Deposition of In2S3 on Cu(In,Ga)(S,Se)2 thin film solar cell absorbers by spray ion layer gas reaction: Evidence of strong interfacial diffusion. **BÄR M. et al.** Applied Physics Letters. AIP, American Institute of Physics, Marz 2007, vol. 90, 132118-1, 132118-3
- **C.T. EWING, K.H. STERN.** Equilibrium Vaporization Rates and Vapor Pressures of Solid and Liquid Sodium Chloride, Potassium Chloride, Potassium Bromide, Cesium Iodide, and Lithium Fluoride. *J. Phys. Chem.,* 1974, vol. 78 (20), 1998-2005